# EUROPEAN PATENT SPECIFICATION

(11) **EP 2 949 780 B1**
(45) Date of publication and mention of the grant of the patent: **08.08.2018**
(21) Application number: 14743015.1
(22) Date of filing: 21.01.2014
(51) Int. Cl.: C23C 14/34, C22C 5/06, C22F 1/00, C22F 1/14, H01J 37/34

(54) **Ag ALLOY FILM-FORMING SPUTTERING TARGET, Ag ALLOY FILM, Ag ALLOY REFLECTIVE FILM, Ag ALLOY ELECTROCONDUCTIVE FILM, Ag ALLOY SEMI-PERMEABLE FILM**
SILBERLEGIERUNGSFILMBILDENDES SPUTTERTARGET, SILBERLEGIERUNGSFILM, REFLEKTIERENDER SILBERLEGIERUNGSFILM, ELEKTRISCH LEITENDER SILBERLEGIERUNGSFILM, HALBDURCHLÄSSIGER SILBERLEGIERUNGSFILM
CIBLE DE PULVÉRISATION FORMANT UN FILM D'ALLIAGE D'aG, FILM D'ALLIAGE D'aG, FILM RÉFLÉCHISSANT EN ALLIAGE D'aG, FILM ÉLECTROCONDUCTEUR EN ALLIAGE D'aG, FILM SEMI-PERMÉABLE EN ALLIAGE D'aG

(30) Priority: 23.01.2013 JP 2013010070; 14.01.2014 JP 2014004584
(43) Date of publication of application: 02.12.2015
(73) Proprietor: Mitsubishi Materials Corporation, Chiyoda-ku Tokyo 100-8117 (JP)
(72) Inventor: TOSHIMORI Yuto, Sanda-shi Hyogo 669-1339 (JP); NONAKA Sohei, Sanda-shi Hyogo 669-1339 (JP)
(74) Representative: Hoffmann Eitle
(86) International application number: PCT/JP2014/051080
(87) International publication number: WO 2014/115712

(56) References cited:
- WO-A1-2006/132414
- JP-A- H1 143 750
- JP-A- 2002 117 587
- JP-A- 2004 002 929
- JP-A- 2004 126 497
- JP-A- 2004 339 585
- JP-A- 2005 008 983
- JP-A- 2013 216 976
- JP-B1- 5 159 962
- JP-B1- 5 159 963
- US-A1- 2004 028 912

## Description

### TECHNICAL FIELD

The present invention relates to a sputtering target for forming a Ag alloy film (Ag alloy reflective film, Ag alloy conductive film, Ag alloy semi-transparent film), a Ag alloy film, a Ag alloy reflective film, a Ag alloy conductive film, and a Ag alloy semi-transparent film, in which the Ag alloy film is used for, for example, a light reflection layer of a display, a light-emitting element used for illumination, an optical recording disk, and the like; a wiring of a touch panel and the like; an infrared ray cut film; or a transparent conductive film.

### BACKGROUND ART

In general, in order to improve light extraction efficiency, a light reflection layer is formed in, for example, a display such as an organic EL or a reflective liquid crystal, a light-emitting element such as an LED, or an optical recording disk. Here, a Ag film and a Ag alloy film formed of Ag and a Ag alloy have high reflectance and thus are widely used as the above-described light reflection layer.

For example, Patent Document 1 discloses that a Ag alloy is used as a constituent material of a repeller of an organic EL element.

Patent Document 2 discloses that Ag or a Ag alloy reflecting light with high efficiency is used as a constituent material of an electrode of a semiconductor light-emitting element.

Patent Document 3 discloses that Ag or a Ag alloy is used as a constituent material of a reflective layer of an optical recording medium.

In addition, a Ag film and a Ag alloy film are used, for example, not only for the above-described uses but also for a reflective mirror for an optical device, a reflective layer for a solar cell, and a reflector of an illumination device.

Additionally, the Ag film and the Ag alloy film described above are superior in conductivity and thus are used as a lead-out wiring of a touch panel, for example, as disclosed in Patent Document 4. Further, as disclosed in Patent Document 5, a Ag film having a thin thickness is used as a semi-transparent film. The semi-transparent film formed of Ag is used as a transparent conductive film for a display or as an anode of a bottom emission organic EL.

### Citation List

### Patent Document

[Patent Document 1] Japanese Unexamined Patent Application, First Publication No. 2012-059576
[Patent Document 2] Japanese Unexamined Patent Application, First Publication No. 2006-245230
[Patent Document 3] Japanese Unexamined Patent Application, First Publication No. 2004-322556
[Patent Document 4] Japanese Unexamined Patent Application, First Publication No. 2009-031705
[Patent Document5] Japanese Patent No. 4395844

In addition to the above, US 2004/0028912 A1 which discloses a sputtering target for forming a silver base alloy thin film, and JP 1999-43750 A which discloses a method for production of a silver alloy, have been found to be related to the present invention.

### DISCLOSURE OF INVENTION

### Technical Problem

However, a Ag film formed of pure Ag is superior in optical characteristics such as reflectance or transmittance but is insufficient in environment resistance (resistance to a moisture-resistant environment). Therefore, optical characteristics such as reflectance or transmittance deteriorate in a usage environment, and thus there is a problem in reliability during long-time use.

In addition, in the light-emitting element and the display described above, a high-temperature heat treatment is performed during a manufacturing process thereof. Therefore, the reflectance of a Ag film or a Ag alloy film is decreased after the heat treatment, and there is a concern that sufficient characteristics cannot be exhibited. Therefore, a Ag alloy film is required which is capable of preventing a decrease in reflectance even after a heat treatment while maintaining reflectance as high as that of a pure Ag film.

Further, when a Ag film formed of pure Ag is used as a wiring, there is a problem in that grains thereof grow in a hot and humid environment, and a specific resistance value changes. In addition, pure Ag is insufficient in various resistances such as salt water resistance, heat resistance, and moisture resistance. Therefore, a Ag film formed of pure Ag may be modified in a usage environment or a manufacturing process.

The present invention has been made in consideration of the above-described circumstances, and an object thereof is to provide a sputtering target for forming a Ag alloy film capable of forming a Ag alloy film; a Ag alloy film; and a Ag alloy conductive film, a Ag alloy reflective film, and a Ag alloy semi-transparent film which are formed of the Ag alloy film, in which optical characteristics such as reflectance or transmittance are superior, a specific resistance value is low, various resistances such as heat resistance and environment resistance are superior, the reflectance does not significantly change even after a heat treatment, and the optical characteristics such as reflectance or transmittance and the specific resistance value do not significantly change in a usage environment.

### Solution to Problem

According to the present invention, in order to solve the above-described problems, there is provided the subject-matter of the independent claim. Further embodiments are described in the dependent claims.

In the sputtering target for forming a Ag alloy film having the claimed configuration, the Sb content is 0.2 at% or higher. Therefore, heat resistance and environment resistance can be improved, a significant decrease in reflectance can be suppressed even when a heat treatment or the like is performed during a manufacturing process after film formation, and optical characteristics such as reflectance or transmittance and a specific resistance value do not significantly change during long-time use. In addition, the Sb content is 2.0 at% or lower. Therefore, superior optical characteristics and a low specific resistance value can be maintained immediately after film formation.

In addition, the Mg content is 0.05 at% or higher. Therefore, grain growth of Ag can be suppressed, heat resistance can be significantly improved due to the synergistic effect with Sb, and salt water resistance can be improved. In addition, the Mg content is 1.00 at% or lower. Therefore, while securing superior optical characteristics and a low specific resistance value, a significant change in the optical characteristics such as reflectance or transmittance and the specific resistance value in a hot and humid environment can be suppressed.

Due to the above-described reasons, a Ag alloy film can be formed in which optical characteristics immediately after film formation are superior, a specific resistance value is low, the reflectance does not significantly change even when a heat treatment or the like is performed during a manufacturing process after film formation, and optical characteristics such as reflectance or transmittance and a specific resistance value do not significantly change in a usage environment.

If in the sputtering target for forming a Ag alloy film an atomic ratio of Sb to Mg satisfies 1.0≤Sb/Mg≤40.0,

A Ag alloy film can be formed in which a change in the reflectance and the resistance value in a hot and humid environment is small.

According to an embodiment of the present invention, there is provided a Ag alloy film which is formed using the above-described sputtering target for forming a Ag alloy film.

In the Ag alloy reflective film having the claimed configuration, various resistances such as heat resistance and environment resistance are superior, the reflectance does not significantly change even when a heat treatment or the like is performed during a manufacturing process after film formation, and optical characteristics such as reflectance or transmittance and a specific resistance value do not significantly change in a usage environment.

According to an embodiment of the present invention, there is provided a Ag alloy reflective film which is formed using the above-described sputtering target for forming a Ag alloy film.

In the Ag alloy reflective film having the claimed configuration, various resistances such as heat resistance and environment resistance are superior, the reflectance does not decrease even when a heat treatment or the like is performed during a manufacturing process after film formation, and the reflectance does not significantly change in a usage environment. Therefore, the Ag alloy reflective film is particularly suitable as a light reflection film of, for example, a light-emitting element such as an LED, a display such as an organic EL or a reflective liquid crystal, or an optical recording disk.

According to an embodiment of the present invention, there is provided a Ag alloy conductive film which is formed using the above- described sputtering target for forming a Ag alloy film.

In the Ag alloy conductive film having the claimed configuration, various resistances such as environment resistance and salt water resistance are superior.

Therefore, the appearance does not change due to corrosion in a usage environment. Therefore, the Ag alloy conductive film is particularly superior as a conductive film.

According to an embodiment of the present invention, there is provided a Ag alloy semi-transparent film which is formed using the above-described sputtering target for forming a Ag alloy film.

In the Ag alloy semi-transparent film having the claimed configuration, environment resistance is superior, and the transmittance does not significantly change even in a usage environment. Therefore, the Ag alloy semi-transparent film is particularly superior as a semi-transparent film.

### Advantageous Effects of Invention

As described above, according to the present invention, a sputtering target for forming a Ag alloy film capable of forming a Ag alloy film; a Ag alloy film; and a Ag alloy conductive film, a Ag alloy reflective film, and a Ag alloy semitransparent film which are formed of the Ag alloy film can be provided, in which optical characteristics such as reflectance or transmittance are superior, a specific resistance value is low, various resistances such as heat resistance and environment resistance are superior, the reflectance does not significantly change even after a heat treatment, and the optical characteristics such as reflectance or transmittance and the specific resistance value do no significant change in usage environment.

### BRIEF DESCRIPTION OF THE DRAWINGS

FIG. 1 is an image of an example whose appearance observation result was evaluated as "B" after a temperature and humidity controlled test in Example 2.
FIG. 2 is an image of an example whose appearance observation result was evaluated as "C" after the temperature and humidity controlled test in Example 2.
FIG. 3 is an image of an example whose appearance observation result and optical microscope observation result were evaluated as "A" after a salt water test in Example 2.
FIG. 4 is an image of an example whose appearance observation result and optical microscope observation result were evaluated as "B" after the salt water test in Example 2.
FIG. 5 is an image of an example whose appearance observation result and optical microscope observation result were evaluated as "C" after the salt water test in Example 2.

### BEST MODE FOR CARRYING OUT THE INVENTION

Hereinafter, a sputtering target for forming a Ag alloy film and a Ag alloy film according to an embodiment of the present invention will be described.

The sputtering target for forming a Ag alloy film according to the embodiment is used for forming a Ag alloy film. Here, the Ag alloy film according to the embodiment is used as, for example, a Ag alloy reflective film which is used as a light reflection layer of a display, a light-emitting element, and the like; a Ag alloy conductive film which constitutes a wiring forming a panel surface peripheral portion of a touch panel; and a Ag alloy semi-transparent film which is used as a transparent conductive film or an infrared ray cut film.

### <Sputtering Target for Forming Ag Alloy Film>

The sputtering target for forming a Ag alloy film according to the embodiment is formed of a Ag alloy including, as a composition, 0.2 at% (atomic percent) or higher and 2.0 at% or lower of Sb, 0.05 at% or higher and 1.00 at% or lower of Mg, and a balance consisting of Ag and inevitable impurities.

Hereinafter, the reason why the composition of the sputtering target for forming a Ag alloy film according to the embodiment is limited as described above will be described.

### Sb: 0.2 at% or higher and 2.0 at% or lower

Sb is an element having an effect of improving heat resistance and environment resistance (resistance to a hot and humid environment).

Here, when the Sb content is lower than 0.2 at%, heat resistance and environment resistance are not sufficiently improved. On the other hand, when the Sb content exceeds 2.0 at%, the reflectance immediately after film formation is low, and characteristics as a reflective film may not be maintained. In addition, the specific resistance value increases, the transmittance decreases, and characteristics as a conductive film or a semi-transparent film may not be maintained.

Due to the above-described reasons, in the embodiment, the Sb content is set in a range of 0.2 at% or higher and 2.0 at% or lower. In order to reliably exhibit the above-described effects, it is preferable that the Sb content be in a range of 0.3 at% or higher and 1.5 at% or lower.

### Mg: 0.05 at% or higher and 1.00 at% or lower

Mg is an element having an effect of suppressing the grain growth of Ag in a hot and humid environment. In addition, due to the synergistic effect with the above-described addition of Sb, Mg also has an effect of improving heat resistance at a high temperature. In addition, Mg also has an effect of improving salt water resistance.

Here, when the Mg content is lower than 0.05 at%, the grain growth is not sufficiently suppressed, and heat resistance and environment resistance may not be improved. In addition, salt water resistance may also not be improved. On the other hand, when the Mg content exceeds 1.00 at%, the reflectance in a hot and humid environment is greatly decreased, and characteristics as a reflective film may not be maintained. In addition, the specific resistance value increases, the transmittance decreases, and characteristics as a conductive film or a semi-transparent film may not be maintained.

Due to the above-described reasons, in the embodiment, the Mg content is set in a range of 0.05 at% or higher and 1.00 at% or lower. In order to reliably exhibit the above-described effects, it is preferable that the Mg content be in a range of 0.10 at% or higher and 0.50 at% or lower.

In addition, by setting the Mg content such that an atomic ratio of Mg to Sb satisfies 1.0≤Sb/Mg≤40.0, a change in the reflectance and the resistance value in a hot and humid environment can be further decreased.

### <Ag Alloy Film>

As described above, the Ag alloy film according to the embodiment is used as a light reflection layer of a display, a light-emitting element, and the like. In the above-described uses, it is required that the reflectance to light having a specific wavelength be high or a reflectance to light in a wide wavelength region be high. In addition, when a light reflection layer is formed during a manufacturing process of a display or a light-emitting element, a heat treatment is performed at, for example, 250°C or higher, after forming the light reflection layer. Therefore, it is necessary to maintain a high reflectance after the heat treatment. Further, in order to improve reliability, it is preferable that the reflectance is stable after long time use without a significant change.

Further, as described above, the Ag alloy film according to the embodiment is used as a Ag alloy reflective film which is used as a light reflection layer of a display, a light-emitting element, and the like; a Ag alloy conductive film which constitutes a wiring forming a panel surface peripheral portion of a touch panel; and a Ag alloy semi-transparent film which is used as a transparent conductive film or an infrared ray cut film. In the above-described uses, it is required that the specific resistance value be low or the transmittance be high. Further, in a usage environment, it is required that the specific resistance value and the transmittance be stable after long time use without a significant change.

In the sputtering target for forming a Ag alloy film and the Ag alloy film (Ag alloy reflective film, Ag alloy conductive film, Ag alloy semi-transparent film) according to the embodiment having the above-described configuration, the Sb content is 0.2 at% or higher and 2.0 at% or lower. Therefore, optical characteristics such as reflectance or transmittance are superior immediately after film formation, a specific resistance value is low, and heat resistance is superior. As a result, a significant change in reflectance can be suppressed even after a heat treatment. Further, since environment resistance is superior, optical characteristics such as reflectance or transmittance and a specific resistance value do not significantly change after long-time use.

In addition, since the Mg content is 0.05 at% or higher and 1.00 at% or lower, optical characteristics such as reflectance or transmittance are superior immediately after film formation, a specific resistance value is low, the grain growth of Ag can be suppressed, and heat resistance and environment resistance can be improved.

Due to the above-described reasons, a Ag alloy film (Ag alloy reflective film, Ag alloy conductive film, Ag alloy semi-transparent film) can be formed in which the reflectance is superior even when a heat treatment or the like is performed during a manufacturing process after film formation, a specific resistance value is low, and optical characteristics such as reflectance or transmittance and a specific resistance value do not significantly change in a usage environment.

In addition, the Ag alloy film (Ag alloy reflective film, Ag alloy conductive film, Ag alloy semi-transparent film) according to the embodiment is formed using the above-described sputtering target for forming a Ag alloy film and thus is superior in heat resistance. Therefore, even when a heat treatment is performed at a relatively high temperature of 250°C or higher during a manufacturing process of a display or a light-emitting element, the reflectance does not significantly change. In addition, since the Ag alloy film is also superior in environment resistance, optical characteristics such as reflectance or transmittance and a specific resistance value are stable without a significant change even in a usage environment.

Hereinabove, the embodiment of the present invention has been described. However, the present invention is not limited to the embodiment, and appropriate modifications can be made within a range not departing from the technical scope of the present invention.

For example, in the above description of the embodiment, the Ag alloy film according to the embodiment is used as, for example, a Ag alloy reflective film which is used as a light reflection layer of a display, a light-emitting element, and the like; a Ag alloy conductive film which constitutes a wiring forming a panel surface peripheral portion of a touch panel; and a Ag alloy semi-transparent film which is used as a transparent conductive film or an infrared ray cut film. However, the present invention is not limited to the above-described uses and is applicable to other uses.

### EXAMPLES

### (Example 1)

Hereinafter, the results of evaluation tests will be described in which the effects of the sputtering target for forming a Ag alloy film and the Ag alloy film (Ag alloy reflective film) according to the present invention were evaluated.

### <Sputtering Target for Forming Ag Alloy Film>

As raw materials to be melted, Ag having a purity of 99.9 mass% or higher, and Sb and Mg having a purity of 99.9% mass% or higher were prepared and were weighed so as to obtain a predetermined composition shown in Table 1.

Next, using a melting furnace, Ag was melted in an inert gas atmosphere, and then Sb and Mg were added to the obtained molten Ag and were melted in an inert gas atmosphere. Next, the molten alloy was cast into a mold to obtain an ingot having a composition shown in Table 1. More specifically, during the melting of Ag, a vacuum atmosphere (5×10⁻² Pa or lower) was made first, and then the vacuum was replaced with Ar gas. In addition, the addition of Sb and Mg was performed in an Ar gas atmosphere.

Next, the obtained ingot was cold-rolled into a sheet at a rolling reduction of 70%, and the obtained sheet was subjected to a heat treatment of being held in air at 600°C for 2 hours. Next, the sheet was subjected to machining. As a result, sputtering targets having compositions of Examples 1 to 9 according to the present invention and sputtering targets having compositions of Comparative Examples 1 to 4 were prepared, for all of which the diameter was 152.4 mm and the thickness was 6 mm.

In addition, as Conventional Example, a sputtering target formed of pure Ag (having a purity of 99.9 mass% or higher) and having the above-described dimensions was prepared.

### <Ag Alloy Reflective Film>

Using the above-described sputtering targets of Examples 1 to 9 according to the present invention and Comparative Examples 1 to 4, Ag alloy films (Ag alloy reflective films) were formed under the following conditions.

Each of the above-described sputtering targets of Examples 1 to 9 according to the present invention and Comparative Examples 1 to 4 was soldered to a backing plate of oxygen-free copper using an indium solder to constitute a target complex. This target complex was mounted on a sputtering device to perform sputtering under conditions of: a distance from a glass substrate (EAGLE XG, manufactured by Corning Inc.) of 70 mm; a power of DC 250 W; an ultimate vacuum degree of 5×10⁻⁵ Pa; and an Ar gas pressure of 0.6 Pa. As a result, a sample was prepared in which a Ag alloy film (Ag alloy reflective film) having a thickness of 100 nm was formed on a surface of the glass substrate.

The above-described sputtering target of Conventional Example was soldered to a backing plate of oxygen-free copper using an indium solder to constitute a target complex. This target complex was mounted on a sputtering device to perform sputtering under the same conditions as above. As a result, a sample was prepared in which a Ag film (Ag reflective film) having a thickness of 100 nm was formed on a surface of the glass substrate.

### <Measurement of Reflectance>

The reflectance R₀ of each of the above-obtained Ag alloy film (Ag alloy reflective film) and the above-obtained Ag film (Ag reflective film) immediately after film formation was measured using a spectrophotometer and light in a wavelength region of 800 nm to 400 nm. The reflectance of light having a wavelength of 405 nm is shown in Table 1, the reflectance of light having a wavelength of 450 nm is shown in Table 2, and the reflectance of light having a wavelength of 550 nm is shown in Table 3.

### <Heat-Resistance Test>

The above-described sample was subjected to a heat treatment under conditions of a nitrogen atmosphere, a temperature of 500°C, and a holding time of 1 hour.

The reflectance R₁ of each of the Ag alloy film (Ag alloy reflective film) and the Ag film (Ag reflective film) after this heat-resistance test was measured using the same method as above. A change amount (R₁-R₀) between the reflectances before and after the heat-resistance test was obtained. The reflectance of light having a wavelength of 405 nm after the heat-resistance test and a change amount of the reflectance are shown in Table 1. The reflectance of light having a wavelength of 450 nm after the heat-resistance test and a change amount of the reflectance are shown in Table 2. The reflectance of light having a wavelength of 550 nm after the heat-resistance test and a change amount of the reflectance are shown in Table 3.

### <Temperature and Humidity Controlled Test (Moisture-Resistant Test)>

The above-described sample was left to stand in a thermostat at a temperature of 85°C and a humidity of 85% for 250 hours.

The reflectance R₂ of each of the Ag alloy film (Ag alloy reflective film) and the Ag film (Ag reflective film) after this temperature and humidity controlled test was measured using the same method as above. A change amount (R₂-R₀) between the reflectances before and after the temperature and humidity controlled test was obtained. The reflectance of light having a wavelength of 405 nm after the temperature and humidity controlled test and a change amount of the reflectance are shown in Table 1. The reflectance of light having a wavelength of 450 nm after the temperature and humidity controlled test and a change amount of the reflectance are shown in Table 2. The reflectance of light having a wavelength of 550 nm after the temperature and humidity controlled test and a change amount of the reflectance are shown in Table 3.

**[Table 1]**

| Reflectance at Wavelength of 405 nm | | | | | | | | | | |
|---|---|---|---|---|---|---|---|---|---|---|
| | | Component Composition | | | | Reflectance R₀ (%) after Film Formation | After Heat-Resistance Test at 500°C | | After Moisture-Resistance Test | |
| | | Sb (at%) | Mg (at%) | Ag | Sb/Mg Composition Ratio | | Reflectance R₁ (%) | Change R₁-R₀ (%) between Reflectances | Reflectance R₂ (%) | Change R₂-R₀ (%) between Reflectances |
| Examples According to Present Invention | 1 | 0.20 | 0.20 | Balance | 1.0 | 94.0 | 92.7 | -1.3 | 90.3 | -3.7 |
| | 2 | 0.50 | 0.20 | Balance | 2.5 | 93.6 | 92.6 | -1.0 | 90.4 | -3.2 |
| | 3 | 1.00 | 0.20 | Balance | 5.0 | 93.0 | 92.5 | -0.5 | 90.8 | -2.2 |
| | 4 | 1.50 | 0.20 | Balance | 7.5 | 92.5 | 92.3 | -0.2 | 91.2 | -1.3 |
| | 5 | 2.00 | 0.20 | Balance | 10.0 | 92.1 | 92.1 | 0.0 | 91.3 | -0.8 |
| | 6 | 0.50 | 0.05 | Balance | 10.0 | 93.7 | 92.0 | -1.7 | 92.0 | -1.7 |
| | 7 | 0.50 | 0.10 | Balance | 5.0 | 93.7 | 92.6 | -1.1 | 91.8 | -1.9 |
| | 8 | 0.50 | 0.50 | Balance | 1.0 | 93.4 | 93.2 | -0.2 | 89.7 | -3.7 |
| | 9 | 0.50 | 1.00 | Balance | 0.5 | 93.1 | 93.1 | 0.0 | 88.8 | -4.3 |
| Comparative Example | 1 | 0.03 | 0.20 | Balance | 0.2 | 94.2 | 91.4 | -2.8 | 88.1 | -6.1 |
| | 2 | 2.50 | 0.20 | Balance | 12.5 | 90.8 | 90.9 | 0.1 | 90.2 | -0.6 |
| | 3 | 0.50 | 0.01 | Balance | 50.0 | 93.7 | 91.2 | -2.5 | 92.2 | -1.5 |
| | 4 | 0.50 | 1.50 | Balance | 0.3 | 92.7 | 92.6 | -0.1 | 87.8 | -4.9 |
| Conventional Example | | Pure Ag (Purity of 99.99 mass%) | | | | 94.3 | 80.8 | -13.5 | 85.0 | -9.3 |

**[Table 2]**

| Reflectance at Wavelength of 450 nm | | | | | | | | | | |
|---|---|---|---|---|---|---|---|---|---|---|
| | | Component Composition | | | | Reflectance R₀ (%) after Film Formation | After Heat-Resistance Test at 500°C | | After Moisture-Resistance Test | |
| | | Sb (at%) | Mg (at%) | Ag | Sb/Mg Composition Ratio | | Reflectance R₁ (%) | Change R₁-R₀ (%) between Reflectances | Reflectance R₂ (%) | Change R₂-R₀ (%) between Reflectances |
| Examples According to Present Invention | 1 | 0.20 | 0.20 | Balance | 1.0 | 96.0 | 95.0 | -1.0 | 94.0 | -2.0 |
| | 2 | 0.50 | 0.20 | Balance | 2.5 | 95.8 | 95.1 | -0.7 | 94.3 | -1.5 |
| | 3 | 1.00 | 0.20 | Balance | 5.0 | 95.6 | 95.5 | -0.1 | 95.1 | -0.5 |
| | 4 | 1.50 | 0.20 | Balance | 7.5 | 94.5 | 94.6 | 0.1 | 94.2 | -0.3 |
| | 5 | 2.00 | 0.20 | Balance | 10.0 | 94.1 | 94.2 | 0.1 | 93.9 | -0.2 |
| | 6 | 0.50 | 0.05 | Balance | 10.0 | 96.2 | 94.3 | -1.9 | 95.5 | -0.7 |
| | 7 | 0.50 | 0.10 | Balance | 5.0 | 96.0 | 95.2 | -0.8 | 95.1 | -0.9 |
| | 8 | 0.50 | 0.50 | Balance | 1.0 | 95.7 | 95.5 | -0.2 | 93.5 | -2.2 |
| | 9 | 0.50 | 1.00 | Balance | 0.5 | 95.5 | 95.6 | 0.1 | 93.1 | -2.4 |
| Comparative Example | 1 | 0.03 | 0.20 | Balance | 0.2 | 96.2 | 93.6 | -2.6 | 93.2 | -3.0 |
| | 2 | 2.50 | 0.20 | Balance | 12.5 | 92.8 | 93.0 | 0.2 | 92.6 | -0.2 |
| | 3 | 0.50 | 0.01 | Balance | 50.0 | 96.2 | 93.5 | -2.7 | 95.6 | -0.6 |
| | 4 | 0.50 | 1.50 | Balance | 0.3 | 95.3 | 95.3 | 0.0 | 92.5 | -2.8 |
| Conventional Example | | Pure Ag (Purity of 99.99 mass%) | | | | 96.4 | 85.2 | -11.2 | 91.8 | -4.6 |

**[Table 3]**

| Reflectance at Wavelength of 550 nm | | | | | | | | | | |
|---|---|---|---|---|---|---|---|---|---|---|
| | | Component Composition | | | | Reflectance R₀ (%) after Film Formation | After Heat-Resistance Test at 500°C | | After Moisture-Resistance Test | |
| | | Sb (at%) | Mg (at%) | Ag | Sb/Mg Composition Ratio | | Reflectance R₁ (%) | Change R₁-R₀ (%) between Reflectances | Reflectance R₂ (%) | Change R₂-R₀ (%) between Reflectances |
| Examples According to Present Invention | 1 | 0.20 | 0.20 | Balance | 1.0 | 97.4 | 97.0 | -0.4 | 97.0 | -0.4 |
| | 2 | 0.50 | 0.20 | Balance | 2.5 | 97.2 | 97.3 | 0.1 | 97.1 | -0.1 |
| | 3 | 1.00 | 0.20 | Balance | 5.0 | 97.1 | 97.2 | 0.1 | 97.2 | 0.1 |
| | 4 | 1.50 | 0.20 | Balance | 7.5 | 96.6 | 96.8 | 0.2 | 96.7 | 0.1 |
| | 5 | 2.00 | 0.20 | Balance | 10.0 | 96.3 | 96.9 | 0.6 | 96.5 | 0.2 |
| | 6 | 0.50 | 0.05 | Balance | 10.0 | 97.3 | 96.5 | -0.8 | 97.3 | 0.0 |
| | 7 | 0.50 | 0.10 | Balance | 5.0 | 97.3 | 97.3 | 0.0 | 97.2 | -0.1 |
| | 8 | 0.50 | 0.50 | Balance | 1.0 | 97.1 | 97.4 | 0.3 | 96.7 | -0.4 |
| | 9 | 0.50 | 1.00 | Balance | 0.5 | 97.0 | 97_{.}5 | 0.5 | 96.3 | -0.7 |
| Comparative Example | 1 | 0.03 | 0.20 | Balance | 0.2 | 97.7 | 95.7 | -2.0 | 96.4 | -1.3 |
| | 2 | 2.50 | 0.20 | Balance | 12.5 | 95.1 | 95.8 | 0.7 | 95.3 | 0.2 |
| | 3 | 0.50 | 0.01 | Balance | 50.0 | 97.3 | 95.4 | -1.9 | 97.5 | 0.2 |
| | 4 | 0.50 | 1.50 | Balance | 0.3 | 96.8 | 97.4 | 0.6 | 95.7 | -1.1 |
| Conventional Example | | Pure Ag (Purity of 99.99 mass%) | | | | 97.8 | 90.3 | -7.5 | 96.3 | -1.5 |

In Comparative Example 1 in which the Sb content was lower than the range of the present invention, in all the wavelengths of 405 nm, 450 nm, and 550 nm, the reflectance after the heat-resistance test was low, and the change amount between the reflectances before and after the temperature and humidity controlled test was large.

In Comparative Example 2 in which the Sb content was higher than the range of the present invention, in all the wavelengths of 405 nm, 450 nm, and 550 nm, the reflectance immediately after film formation was low.

In Comparative Example 3 in which the Mg content was lower than the range of the present invention, in all the wavelengths of 405 nm, 450 nm, and 550 nm, the reflectance after the heat-resistance test was low.

In Comparative Example 4 in which the Mg content was higher than the range of the present invention, in all the wavelengths of 405 nm, 450 nm, and 550 nm, the change between the reflectances before and after the temperature and humidity controlled test was large.

In Conventional Example in which pure Ag was used, in all the wavelengths of 405 nm, 450 nm, and 550 nm, the reflectance after the heat-resistance test was low, and the change amount between the reflectances before and after the temperature and humidity controlled test was large.

On the other hand, in Examples 1 to 9 according to the present invention in which the contents of Sb and Mg were in the range of the present invention, in all the wavelengths of 405 nm, 450 nm, and 550 nm, the reflectance immediately after film formation was high, and the reflectance after the heat-resistance test was also high. In addition, the change amount between the reflectances before and after the temperature and humidity controlled test was small, and it was found that the reflectance was stable.

It can be seen from the above results that, in Examples according to the present invention, a Ag alloy film (Ag alloy reflective film) having high reflectance and superior heat resistance and environment resistance, and a sputtering target capable of forming the Ag alloy film (Ag alloy reflective film) can be provided.

### (Example 2)

Next, the results of evaluation tests will be described in which the effects of the sputtering target for forming a Ag alloy film and the Ag alloy film (Ag alloy conductive film) according to the present invention were evaluated.

### <Sputtering Target for Forming Ag Alloy Film>

As raw materials to be melted, Ag having a purity of 99.9 mass% or higher, and Sb and Mg having a purity of 99.9% mass% or higher were prepared and were weighed so as to obtain a predetermined composition shown in Table 4.

Next, using a melting furnace, Ag was melted in an inert gas atmosphere, and then Sb and Mg were added to the obtained molten Ag and were melted in an inert gas atmosphere. Next, the molten alloy was cast into a mold to obtain an ingot having a composition shown in Table 4. More specifically, during the melting of Ag, a vacuum atmosphere (5×10⁻² Pa or lower) was made first, and then the vacuum was replaced with Ar gas. In addition, the addition of Sb and Mg was performed in an Ar gas atmosphere.

Next, the obtained ingot was cold-rolled into a sheet at a rolling reduction of 70%, and the obtained sheet was subjected to a heat treatment of being held in air at 600°C for 2 hours. Next, the sheet was subjected to machining. As a result, sputtering targets having compositions of Examples 11 to 17 according to the present invention and sputtering targets having compositions of Comparative Examples 11 to 14 were prepared, for all of which the diameters were 152.4 mm and the thicknesses were 6 mm. In addition, as Conventional Example, a sputtering target formed of pure Ag (having a purity of 99.9 mass% or higher) and having the above-described dimension was prepared.

### <Ag Alloy Conductive Film>

Using the above-described sputtering targets of Examples 11 to 17 according to the present invention and Comparative Examples 11 to 14, Ag alloy films (Ag alloy conductive films) were formed under the following conditions.

Each of the above-described sputtering targets of Examples 11 to 17 according to the present invention and Comparative Examples 11 to 14 was soldered to a backing plate of oxygen-free copper using an indium solder to constitute a target complex. This target complex was mounted on a sputtering device to perform sputtering under conditions of: a distance from a glass substrate (EAGLE XG, manufactured by Corning Inc.) of 70 mm; a power of DC 250 W; an ultimate vacuum degree of 5×10⁻⁵ Pa; and an Ar gas pressure of 0.6 Pa. As a result, a sample was prepared in which a Ag alloy film (Ag alloy conductive film) having a thickness of 100 nm was formed on a surface of the glass substrate.

The above-described sputtering target of Conventional Example was soldered to a backing plate of oxygen-free copper using an indium solder to constitute a target complex. This target complex was mounted on a sputtering device to perform sputtering under the same conditions as above. As a result, a sample was prepared in which a Ag film (Ag reflective film) having a thickness of 100 nm was formed on a surface of the glass substrate.

### <Specific Resistance Value after Film Formation>

The sheet resistance value of each of the above-obtained Ag alloy film (Ag alloy conductive film) and the above-obtained Ag film (Ag reflective film) was measured using a four-point probe method to calculate a specific resistance value. The obtained specific resistance value after film formation is shown in Table 4.

### <Temperature and Humidity Controlled Test>

The above-described sample was left to stand in a thermostat at a temperature of 85°C and a humidity of 85% for 250 hours.

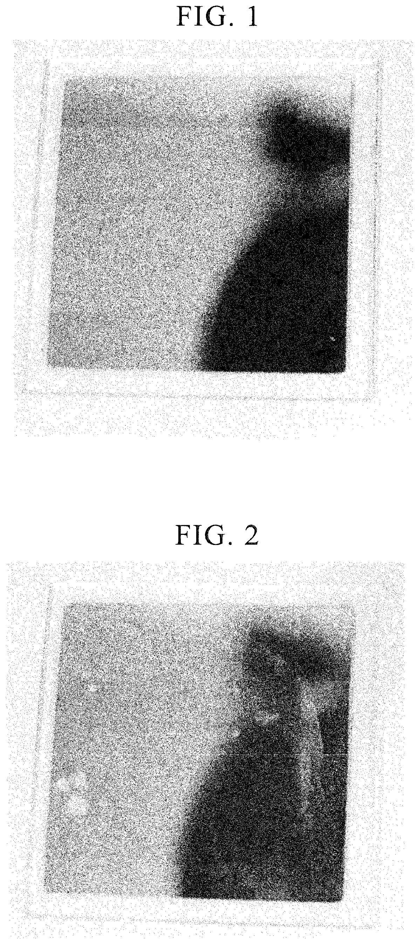

When the appearance of the sample after the temperature and humidity controlled test was visually inspected, a sample in which there was no change in appearance before and after the temperature and humidity controlled test was evaluated as "B", and a sample where dark spots or turbid points formed by corrosion were observed was evaluated as "C". The evaluation results are shown in Table 4. FIG. 1 shows an example whose appearance observation result was evaluated as "B". FIG. 2 shows an example whose appearance observation result was evaluated as "C". Here, a dark shade in FIGS. 1 and 2 is a shade of a camera lens, and small and large white circles in FIG. 2 are turbid points.

### <Salt Water Test>

By using a glass substrate provided with an ITO film (thickness: 10 nm) as a substrate, a Ag alloy film (Ag alloy conductive film) and a Ag film (Ag conductive film) were formed so as to prepare samples.

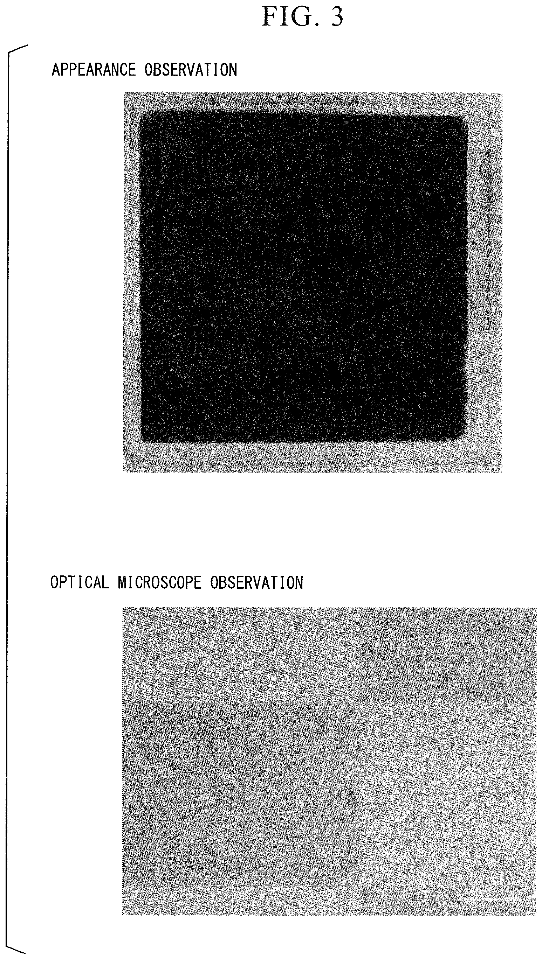

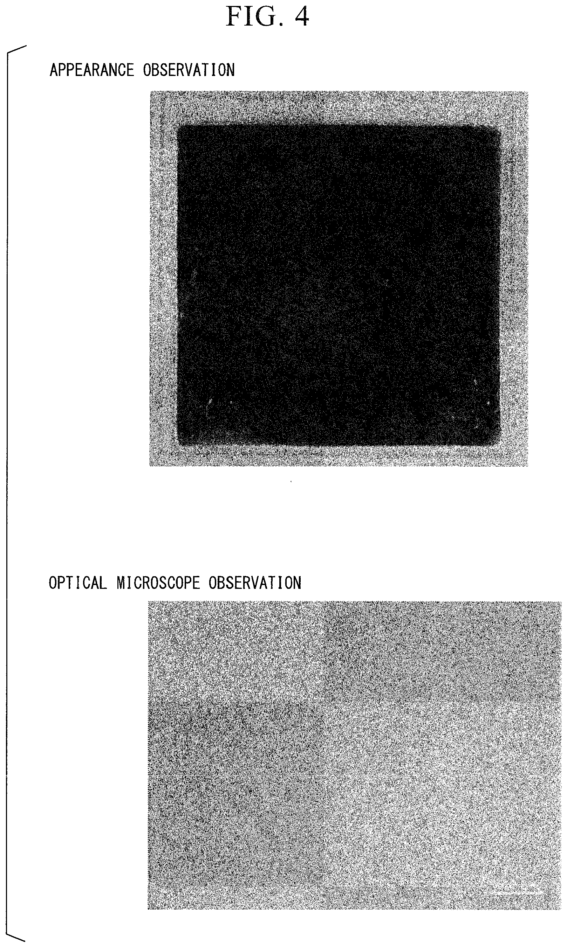

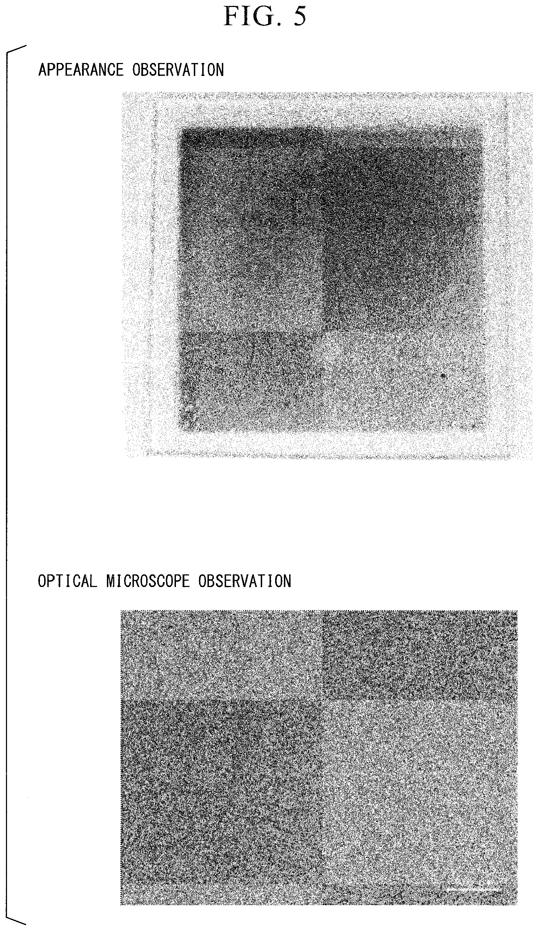

These samples were dipped in a 5% NaCl aqueous solution for 12 hours and were pulled out. Next, the appearance was visually inspected and was observed using an optical microscope. A sample where no change in the appearance was found in the optical microscope observation was evaluated as "A". A sample where a decrease in gloss was not found in the visual inspection but a dark spot was found in the optical microscope observation was evaluated as "B". A sample where a turbid point formed by corrosion was found in the visual inspection was evaluated as "C". The evaluation results are shown in Table 4. FIG. 3 shows an example whose appearance observation result and optical microscope observation result were evaluated as "A". FIG. 4 shows an example whose appearance observation result and optical microscope observation result were evaluated as "B". FIG. 5 shows an example whose appearance observation result and optical microscope observation result were evaluated as "C".

**[Table 4]**

| | | Component Composition of Target | | | | Resistance Value (µΩ·cm) after Film Formation | Appearance Evaluation after Temperature and Humidity Controlled Test | Appearance Evaluation after Salt Water Test |
|---|---|---|---|---|---|---|---|---|
| | | Sb (at%) | Mg (at%) | Ag | Sb/Mg Composition Ratio | | | |
| Examples According to Present Invention | 11 | 0.20 | 0.20 | Balance | 1.0 | 3.56 | B | B |
| | 12 | 0.50 | 0.20 | Balance | 2.5 | 3.98 | B | B |
| | 13 | 1.00 | 0.20 | Balance | 5.0 | 4.78 | B | B |
| | 14 | 2.00 | 0.20 | Balance | 10.0 | 6.17 | B | B |
| | 15 | 0.50 | 0.05 | Balance | 10.0 | 3.32 | B | B |
| | 16 | 0.50 | 0.50 | Balance | 1.0 | 4.23 | B | B |
| | 17 | 0.50 | 1.00 | Balance | 0.5 | 4.79 | B | A |
| Comparative Example | 11 | 0.03 | 0.20 | Balance | 0.2 | 3.14 | C | B |
| | 12 | 3.50 | 0.20 | Balance | 17.5 | 8.68 | B | B |
| | 13 | 0.50 | 0.01 | Balance | 50.0 | 3.28 | B | C |
| | 14 | 0.50 | 3.00 | Balance | 0.2 | 8.23 | B | A |
| Conventional Example | | Pure Ag (Purity of 99.99 mass%) | | | | 3.15 | C | B |

In Comparative Example 11 in which the Sb content was lower than the range of the present invention, after the temperature and humidity controlled test, corrosion was observed in the appearance observation, and it was found that moisture resistance was insufficient.

In Comparative Example 12 in which the Sb content was higher than the range of the present invention, the specific resistance value after film formation was high.

In Comparative Example 13 in which the Mg content was lower than the range of the present invention, after the salt water test, corrosion was observed in the appearance observation, and it was found that salt water resistance was insufficient.

In Comparative Example 14 in which the Mg content was higher than the range of the present invention, the specific resistance value after film formation was high.

In Conventional Example in which pure Ag was used, after the temperature and humidity controlled test and after the salt water test, corrosion was observed in the appearance observation, and the moisture resistance and salt water resistance were insufficient.

On the other hand, in Examples 11 to 17 in which the contents of Sb and Mg were in the range of the present invention, the specific resistance value after film formation was low, and after the temperature and humidity controlled test and after the salt water test, corrosion was not observed in the appearance observation.

It can be seen from the above results that, in Examples according to the present invention, a Ag alloy film (Ag alloy conductive film) having a low specific resistance value and superior moisture resistance and salt water resistance, and a sputtering target for forming the Ag alloy film can be provided.

### (Example 3)

Next, the results of evaluation tests will be described in which the effects of the Ag alloy film (Ag alloy semi-transparent film) formed using the sputtering target according to Example 2 were evaluated.

### <Ag Alloy Film (Ag Alloy Semi-Transparent Film)>

The above-described sputtering target was mounted on a sputtering device to perform sputtering under conditions of: a distance from a glass substrate (EAGLE XG, manufactured by Corning Inc.) of 70 mm; a power of DC 250 W; an ultimate vacuum degree of 5×10⁻⁵ Pa or lower; and an Ar gas pressure of 0.6 Pa. As a result, a sample was prepared in which a Ag alloy film (Ag alloy semi-transparent film) having a thickness shown in Table 5 was formed on a surface of the glass substrate.

In addition, using the above-described sputtering target of Conventional Example, a sample was prepared in which a Ag film (Ag semi-transparent film) having a thickness shown in Table 5 was formed on a glass substrate under the same conditions as above.

The thickness of the Ag alloy semi-transparent film was measured as follows. Using a spectroscopic ellipsometer (for example, UNISEL NIR AGM, manufactured by HORIBA Jobin Yvon), optical parameters δ and ψ of the Ag alloy semi-transparent film formed on the glass substrate were measured in a wavelength region of 260 nm to 2100 nm. The thickness was calculated from analysis of the optical parameters δ and ψ. Further, the thickness of the Ag alloy semi-transparent film was also obtained by observing a cross-section of the film using a transmission electron microscope (TEM). A sample for observing the cross-section using the TEM can be prepared using, for example, a cross-section polisher (CP) or a focused ion beam method (FIB).

### <Specific Resistance Value after Film Formation>

The sheet resistance value of each of the above-obtained Ag alloy film (Ag alloy semi-transparent film) and the above-obtained Ag film (Ag semi-transparent film) was measured using a four-point probe method to calculate a specific resistance value. The obtained specific resistance value after film formation is shown in Table 6.

### <Measurement of Transmittance>

Using a spectrophotometer (Ubest Series, manufactured by JASCO Corporation), the transmittance of each of the Ag alloy film (Ag alloy semi-transparent film) and the Ag film (Ag semi-transparent film) was measured in a wavelength region of 850 nm to 350 nm. During the measurement of the transmittance, the measurement was initially performed in a hollow state where the substrate was not set in the spectrophotometer so as to perform calibration of the spectrophotometer. Next, the transmittance Ts of the glass substrate on which the Ag alloy film (Ag alloy semi-transparent film) and the Ag film (Ag semi-transparent film) were not formed was measured. Next, the transmittance Tt of the glass substrate on which the Ag alloy film (Ag alloy semi-transparent film) and the Ag film (Ag semi-transparent film) were formed was measured. Next, the transmittance Tf of each of the Ag alloy film (Ag alloy semi-transparent film) and the Ag film (Ag semi-transparent film) was calculated from Tf=Tt/Ts. Table 6 shows the measurement results. The transmittance values shown in Table 5 are average values in a wavelength region of 850 nm to 350 nm.

### <Temperature and Humidity Controlled Test>

The above-described sample was left to stand in a thermostat at a temperature of 85°C and a humidity of 85% for 250 hours.

The specific resistance value and the transmittance Tf₁ of each of the Ag alloy film (Ag alloy semi-transparent film) and the Ag film (Ag semi-transparent film) after this temperature and humidity controlled test was measured using the same method as above. The measurement results are shown in Table 6.

A change rate of the specific resistance values before and after the temperature and humidity controlled test was obtained. In addition, a change amount (Tf₁-Tf₀) between the transmittances before and after the temperature and humidity controlled test was obtained. The change rate of the specific resistance values and the change amount between the transmittances before and after the temperature and humidity controlled test are shown in Table 6.

**[Table 5]**

| | | Component Composition of Target | | | | Thickness (nm) of Ag Alloy Film (Ag Film) |
|---|---|---|---|---|---|---|
| | | Sb (at%) | Mg (at%) | Ag | Sb/Mg Composition Ratio | |
| Examples According to Present Invention | 21 | 0.20 | 0.20 | Balance | 1.0 | 15 |
| | 22 | 0.50 | 0.20 | Balance | 2.5 | 15 |
| | 23 | 1.00 | 0.20 | Balance | 5.0 | 15 |
| | 24 | 2.00 | 0.20 | Balance | 10.0 | 15 |
| | 25 | 0.50 | 0.05 | Balance | 10.0 | 15 |
| | 26 | 0.50 | 0.50 | Balance | 1.0 | 15 |
| | 27 | 0.50 | 1.00 | Balance | 0.5 | 15 |
| | 28 | 0.50 | 0.20 | Balance | 2.5 | 10 |
| | 29 | 0.50 | 0.20 | Balance | 2.5 | 5 |
| Comparative Example | 21 | 0.03 | 0.20 | Balance | 0.2 | 15 |
| | 22 | 3.50 | 0.20 | Balance | 17.5 | 15 |
| | 23 | 0.50 | 0.01 | Balance | 50.0 | 15 |
| | 24 | 0.50 | 3.00 | Balance | 0.2 | 15 |
| Conventional Example | | Pure Ag (Purity of 99.9 mass%) | | | | 15 |

**[Table 6]**

| | | Resistance Value (µΩ·cm) after Film Formation | Resistance Value (µΩ·cm) after Temperature and Humidity Controlled Test | Change Rate (%) of Specific Resistance Values | Average Transmittance Tf₀ (%) after Film Formation | Average Transmittance Tf₀ (%) after Temperature and Humidity Controlled Test | Change Amount Tf₁-Tf₀ of Transmittances |
|---|---|---|---|---|---|---|---|
| Examples According to Present Invention | 21 | 5.42 | 6.03 | 11.3 | 43.0 | 42.9 | -0.1 |
| | 22 | 5.98 | 6.31 | 5.6 | 42.5 | 42.6 | 0.1 |
| | 23 | 6.98 | 6.83 | -2.2 | 41.6 | 41.7 | 0.1 |
| | 24 | 8.75 | 8.29 | -5.3 | 40.2 | 40.5 | 0.3 |
| | 25 | 6.42 | 6.70 | 4.4 | 41.8 | 41.4 | -0.4 |
| | 26 | 6.51 | 7.16 | 10.0 | 40.3 | 40.4 | 0.1 |
| | 27 | 7.12 | 8.25 | 15.9 | 39.5 | 39.9 | 0.4 |
| | 28 | 6.84 | 7.37 | 7.8 | 61.0 | 61.0 | 0.0 |
| | 29 | 8.37 | 9.17 | 9.6 | 84.2 | 83.7 | -0.5 |
| Comparative Example | 21 | 5.35 | 7.13 | 33.2 | 43.8 | 43.0 | -0.8 |
| | 22 | 12.91 | 10.74 | -16.8 | 36.4 | 36.9 | 0.5 |
| | 23 | 5.73 | 5.88 | 2.6 | 42.2 | 40.2 | -2.0 |
| | 24 | 10.87 | 13.65 | 25.6 | 37.5 | 38.5 | 1.0 |
| Conventional Example | | 5.23 | 9.23 | 76.5 | 44.8 | 35.4 | -9.4 |

In Comparative Example 21 in which the Sb content was lower than the range of the present invention, the change between the specific resistance values before and after the temperature and humidity controlled test was large.

In Comparative Example 22 in which the Sb content was higher than the range of the present invention, the specific resistance value after film formation was high, and the transmittance was low. Further, the change between the specific resistance values before and after the temperature and humidity controlled test was large.

In Comparative Example 23 in which the Mg content was lower than the range of the present invention, the change between the transmittances before and after the temperature and humidity controlled test was large.

In Comparative Example 24 in which the Mg content was higher than the range of the present invention, the specific resistance value after film formation was high, and the transmittance was low. Further, the change between the specific resistance values before and after the temperature and humidity controlled test was large.

In Conventional Example in which pure Ag was used, the changes between the specific resistance values and the transmittances before and after the heat treatment were large.

On the other hand, in Examples 21 to 29 in which the contents of Sb and Mg were in the range of the present invention, the specific resistance value after film formation was low, the transmittance was high, the specific resistance values and the transmittances before and after the temperature and humidity controlled test were stable without a significant change.

It can be seen from the above results that, in Examples according to the present invention, a Ag alloy film (Ag alloy semi-transparent film) having a low specific resistance value, high transmittance, and superior heat resistance, moisture resistance, and salt water resistance, and a sputtering target for forming the Ag alloy film can be provided.

### INDUSTRIAL APPLICABILITY

By using the sputtering target for forming a Ag alloy film according to the present invention, a Ag alloy film, a Ag alloy conductive film, a Ag alloy reflective film, and a Ag alloy semi-transparent film can be formed, in which various resistances are superior and optical characteristics are stable even during long-time use.

## Claims

1. A sputtering target for forming a Ag alloy film, the sputtering target having a composition consisting of
0.2 at% or higher and 2.0 at% or lower of Sb,
0.05 at% or higher and 1.00 at% or lower of Mg, and
a balance consisting of Ag and inevitable impurities.

2. The sputtering target for forming a Ag alloy film according to claim 1,
wherein an atomic ratio of Sb to Mg satisfies 1.0≤Sb/Mg≤40.0.

3. A Ag alloy film which is formed using the sputtering target for forming a Ag alloy film according to claim 1 or 2,
wherein the Ag alloy film has a composition consisting of
0.2 at% or higher and 2.0 at% or lower of Sb,
0.05 at% or higher and 1.00 at% or lower of Mg, and
a balance consisting of Ag and inevitable impurities.

4. A Ag alloy reflective film which is formed using the sputtering target for forming a Ag alloy film according to claim 1 or 2,
wherein the Ag alloy reflective film has the composition as defined in claim 3, and
a reflectance in a wavelength region of 405 nm to 550 nm is 85% or more.

5. A Ag alloy conductive film which is formed using the sputtering target for forming a Ag alloy film according to claim 1 or 2,
wherein the Ag alloy conductive film has the composition as defined in claim 3, and
a specific resistance is 10 µΩ·cm or lower.

6. A Ag alloy semi-transparent film which is formed using the sputtering target for forming a Ag alloy film according to claim 1 or 2,
wherein the Ag alloy semi-transparent film has the composition as defined in claim 3,
a thickness is 15 nm or less, and
an average transmittance in a wavelength region of 350 nm to 850 nm is 35% or more.

## Patentansprüche

1. Sputtertarget zum Bilden eines Ag-Legierungsfilms, wobei das Sputtertarget eine Zusammensetzung aufweist, bestehend aus
0,2 Atom-% oder höher und 2,0 Atom-% oder niedriger Sb,
0,05 Atom-% oder höher und 1,00 Atom-% oder niedriger Mg, und
einem Rest, bestehend aus Ag und unvermeidbaren Verunreinigungen.

2. Sputtertarget zum Bilden eines Ag-Legierungsfilms nach Anspruch 1,
wobei ein Atomverhältnis von Sb zu Mg 1,0≤Sb/Mg≤40,0 genügt.

3. Ag-Legierungsfilm, der unter Verwendung des Sputtertargets zum Bilden eines Ag-Legierungsfilms nach Anspruch 1 oder 2 gebildet wird,
wobei der Ag-Legierungsfilm eine Zusammensetzung aufweist, bestehend aus
0,2 Atom-% oder höher und 2,0 Atom-% oder niedriger Sb,
0,05 Atom-% oder höher und 1,00 Atom-% oder niedriger Mg, und
einem Rest, bestehend aus Ag und unvermeidbaren Verunreinigungen.

4. Reflektierender Ag-Legierungsfilm, der unter Verwendung des Sputtertargets zum Bilden eines Ag-Legierungsfilms nach Anspruch 1 oder 2 gebildet wird,
wobei der reflektierende Ag-Legierungsfilm die wie in Anspruch 3 definierte Zusammensetzung aufweist, und
ein Reflexionsgrad in einem Wellenlängenbereich von 405 nm bis 550 nm 85% oder mehr ist.

5. Leitfähiger Ag-Legierungsfilm, der unter Verwendung des Sputtertargets zum Bilden eines Ag-Legierungsfilms nach Anspruch 1 oder 2 gebildet wird,
wobei der leitfähige Ag-Legierungsfilm die wie in Anspruch 3 definierte Zusammensetzung aufweist, und
ein spezifischer Widerstand 10 µΩ.cm oder niedriger ist.

6. Halbtransparenter Ag-Legierungsfilm, der unter Verwendung des Sputtertargets zum Bilden eines Ag-Legierungsfilms nach Anspruch 1 oder 2 gebildet wird,
wobei der halbtransparente Ag-Legierungsfilm die wie in Anspruch 3 definierte Zusammensetzung aufweist,
eine Dicke 15 nm oder weniger ist, und
eine mittlere Durchlässigkeit in einem Wellenlängenbereich von 350 nm bis 850 nm 35% oder mehr ist.

## Revendications

1. Cible de pulvérisation pour former un film d'alliage d'Ag, la cible de pulvérisation ayant une composition constituée
de 0,2 % atomique ou plus et de 2,0 % atomique ou moins de Sb,
de 0,05 % atomique ou plus et de 1,00 % atomique ou moins de Mg ; et
d'un reste constitué d'Ag et d'impuretés inévitables.

2. Cible de pulvérisation pour former un film d'alliage d'Ag selon la revendication 1, dans laquelle un rapport atomique du Sb au Mg vérifie 1,0 ≤ Sb/Mg ≤ 40,0.

3. Film d'alliage d'Ag qui est formé en utilisant la cible de pulvérisation pour former un film d'alliage d'Ag selon la revendication 1 ou 2,
dans lequel le film d'alliage d'Ag a une composition constituée
de 0,2 % atomique ou plus et de 2,0 % atomique ou moins de Sb,
de 0,05 % atomique ou plus et de 1,00 à % atomique ou moins de Mg ; et
d'un reste constitué d'Ag et d'impuretés inévitables.

4. Film réfléchissant en alliage d'Ag qui est formé en utilisant la cible de pulvérisation pour former un film en alliage d'Ag selon la revendication 1 ou 2,
dans lequel le film réfléchissant en alliage d'Ag a la composition telle que définie dans la revendication 3, et
une réflectance dans une région de longueur d'onde de 405 nm à 550 nm est supérieure ou égale à 85 %.

5. Film conducteur en alliage d'Ag qui est formé en utilisant la cible de pulvérisation pour former un film en alliage d'Ag selon la revendication 1 ou 2,
dans lequel le film conducteur en alliage d'Ag a la composition telle que définie dans la revendication 3, et
une résistance spécifique est inférieure ou égale à 10 µΩ·cm.

6. Film semi-transparent en alliage d'Ag qui est formé en utilisant la cible de pulvérisation pour former un film en alliage d'Ag selon la revendication 1 ou 2,
dans lequel le film semi-transparent en alliage d'Ag a la composition telle que définie dans la revendication 3,
une épaisseur est inférieure ou égale à 15 nm ; et
une transmittance moyenne dans une région de longueur d'onde de 350 nm à 850 nm est supérieure ou égale à 35 %.
